# EUROPEAN PATENT APPLICATION

(11) **EP 4 481 799 A1**
(43) Date of publication of application: **25.12.2024**
(21) Application number: 23755790.5
(22) Date of filing: 15.02.2023
(51) Int. Cl.: H01L 21/67, H01L 21/66, G01B 21/16, G01B 21/02

(54) **OPERATION APPARATUS, AND DISTRIBUTED METHOD FOR COMPENSATING FOR SPACING BETWEEN TWO WORKPIECES**

(30) Priority: 17.02.2022 CN 202210146129
(71) Applicant: Parcan NanoTech Co., Ltd., Shanghai 201821 (CN)
(72) Inventor: ZHOU, Xiangqian, Shanghai 201821 (CN)
(74) Representative: Viering, Jentschura & Partner mbB Patent- und Rechtsanwälte
(86) International application number: PCT/CN2023/076068
(87) International publication number: WO 2023/155788

(57) **Abstract**

Embodiments of the present application provide an operating device and a method for distributed compensating a spacing between two workpieces, relating to the fields of measurement and control technology and precision manufacturing technology. The operating device comprises: a control system, at least one spacing compensation unit, a first support layer, an operating workpiece, and a plurality of sensors; the sensors are used to measure a distance between the operating workpiece and a corresponding position on a surface to be operated of the measured workpiece; the control system is used to control the spacing compensation units to adjust the distances between a corresponding target portion on the operating workpiece and the measured workpiece based on the distances measured by the sensors, so as to make the shapes of two opposite surfaces between the operating workpiece and the measured workpiece matched; the target portion is the portion of the operating workpiece overlapped with the spacing compensation unit. In the present application, the distance between the lower surface of the operating workpiece and the surface to be operated of the measured workpiece is kept relatively consistent, which facilitates the operations such as measuring or machining of the measured workpiece by the operating workpiece, and improves the accuracy of measuring and machining of the operating workpiece.

## Description

### Cross-references to related application

This patent application claims priority to Chinese patent application No. 2022101461298 filed on February 17, 2022, entitled "Operating device and method for distributed compensating a spacing between two workpieces", and the full text of said application is incorporated herein by reference.

### Technical field

The present application relates to the field of measurement, control, and precision manufacturing technology, and specifically to an operating device and a method for distributed compensating a spacing between two workpieces.

### Background technology

The machining workpiece is used to machine the machined workpiece, specifically to machine the surface of the machined workpiece facing to the surface of the machining workpiece. When the surfaces of the machining workpiece and the machined workpiece are larger or comparable relative to each other, the relative flatness of the surfaces of the two is important. For example, when it is necessary to performed operations such as measuring, machining on the entire surface of the machined workpiece such as a wafer, the entire surface of the machining workpiece can be parallelly aligned to the machined workpiece such as a wafer on the workbench to perform operations such as measuring or machining. For example, the three-dimensional topography of the wafer surface can be measured using the probe array, the photoresist on the wafer surface can be exposed using the probe array, and the nanoimprint machining can be performed on the wafer surface using the nanoimprint template.

However, the surface of the machined workpiece such as wafers is generally uneven, there will generally be more than a dozen micron order of magnitude of the surface undulation, while the spacing between the surface of the machining workpiece and the surface of the machined workpiece surface is only a few tens of nanometers, i.e., far less than the surface undulation. This will result that during measuring or machining of the wafer, some parts of the machining workpiece has been in contact with the wafer surface, and some parts still have a large spacing to the wafer surface, which will affect the measurement or machining accuracy of the wafer surface, and may even lead to the inability to measure or machine the wafer.

At present, in order to solve the problem that the surface of the machined workpiece is in a curved surface form, the surface of the machined workpiece is generally flattened first to conform with the flat entire surface of the machining workpiece. However, the surface of the machining workpiece itself is not necessarily very flat, so simply flattening the surface of the machined workpiece will not solve the problem of unevenness of the surface of the machined workpiece.

In response to the above pressing problems, the applicant has filed the present application to address the above technical problems.

### Summary of the invention

An object of the present application is to provide an operating device and a method for distributed compensating a spacing between two workpieces, capable of dividing the lower surface of the operating workpiece into a plurality of portions for distributed spacing compensation, and making the shapes of the two opposite surfaces between the operating workpiece and the measured workpiece after the spacing compensation to match to each other, so that the distance between the lower surface of the operating workpiece and the surface to be operated of the measured workpiece is kept relatively consistent over the entire surface of the measured workpiece, which facilitates the operations such as measuring or machining of the machined workpiece by the machining workpiece, and improves the accuracy of measuring and machining of the workpiece.

In order to achieve the above purpose, the present application provides an operating device comprising: a control system, at least one spacing compensation unit, a first support layer, an operating workpiece, and a plurality of sensors provided on said operating workpiece and facing a measured workpiece; said machined workpiece is fixed on a second support layer, said control system is communicatively connected to said spacing compensation units, said control system is communicatively connected to said sensors; said first support layer is fixed to said operating workpiece by said spacing compensation unit; said second support layer is fixed to said measured workpiece; each of said spacing compensation units corresponds to at least one said sensor, each of said spacing compensation units is overlapped spatially with a portion of said operating workpiece, said sensor corresponding to said spacing compensation unit is provided on the portion of said operating workpiece overlapped with said spacing compensation unit; said sensor is used for measuring a distance between said operating workpiece and a corresponding position on the surface to be operated of said workpiece; said control system is used for controlling said spacing compensation units to adjust the distance between a corresponding target portion of said operating workpiece and said measured workpiece based on the distances measured by said sensors, so that the shapes of two opposite surfaces between said operating workpiece and said measured workpiece are matched; said target portion is the portion of said operating workpiece overlapped with said spacing compensation unit.

The present application also provides a distributed spacing compensation method between two workpieces, applied to said operating device, said method comprising: measuring a distance between an operating workpiece and a corresponding position on a surface to be operated of a measured workpiece by a plurality of sensors; based on the distance measured by said sensors, controlling the spacing compensation units to adjust the distance between a corresponding target portion of said operating workpiece and said measured workpiece so as to make the shapes of the two opposite surfaces between said operating workpiece and said measured workpiece matched; said target portion is the portion of said operating workpiece overlapped with said spacing compensation unit.

The present application also provides an operating device comprising: a control system, at least one spacing compensation unit, a first support layer, and a plurality of sensors, said plurality of sensors face to a measured workpiece fixed on a second support layer, said control system is communicatively connected to said spacing compensation units, said control system is communicatively connected to said sensors; each of said spacing compensation units corresponds to at least one of said sensors, one surface of said spacing compensation unit is fixed on said first support layer, and the other surface of said spacing compensation unit is fixed with the corresponding sensor; said sensor is used to measure a distance between the corresponding spacing compensation unit and a corresponding position on said measured workpiece; said control system is used to control and adjust the distance between the corresponding spacing compensation unit and said measured workpiece according to the distance measured by said sensors, so as to make the shape of the surface formed by said plurality of sensors match the shape of the surface to be operated of said measured workpiece.

The present application also provides a distributed spacing compensation method between two workpieces, applied to said operating device, said method comprising: measuring a distance between a corresponding spacing compensation unit and a corresponding position on the surface to be operated of said measured workpiece by a plurality of sensors; based on the distance measured by said sensors, controlling said spacing compensation units to adjust the distance between said spacing compensation unit and said measured workpiece, so as to make the shape of the surface formed by said plurality of sensors match the shape of the surface to be operated of said measured workpiece.

In the embodiments of the present application, the lower surface of the operating workpiece can be divided into a plurality of portions for distributed spacing compensation, and the shapes of the two opposite surfaces between the operating workpiece and the measured workpiece are matched after spacing compensation, so that the distance between the lower surface of the operating workpiece and the surface to be operated of the measured workpiece is kept relatively consistent, which facilitates the measuring or machining of the measured workpiece by the operating workpiece, and improves the accuracy of measuring and machining of the workpiece.

In one embodiment, the number of said spacing compensation units is a plurality, and each said sensor corresponds to one said spacing compensation unit; said control system is used to obtain the distance between said target portion corresponding to said spacing compensation units and said measured workpiece based on the distance measured by said sensor corresponding to said spacing compensation units; said control system is used to control each said spacing compensation units to adjust the distance between the corresponding target portion and said measured workpiece, the adjusted distances between said target portions corresponding to said spacing compensation units and said measured workpiece are equal, so as to make the shapes of the two opposite surfaces between said operating workpiece and said measured workpiece matched.

In one embodiment, said control system is used to generate a control signal for controlling a distance equal to a reference target spacing value corresponding to said spacing compensation units based on a difference between the distance between said target portion corresponding to said spacing compensation units and said measured workpiece and the reference target spacing value; said spacing compensation unit is used to adjust the distance between the corresponding target portion and said measured workpiece to be equal to said reference target spacing value based on said control signal received.

In one embodiment, said control system is used to select a distance between said target portion and said measured workpiece which is smaller than a preset target spacing value as said reference target spacing value when there exists a distance between said target portion and said measured workpiece corresponding to any of said spacing compensation units which is smaller than said preset target spacing value; said control system is used to control said first support layer to drive said operating workpiece to move towards said measured workpiece in such a way that the distance between said target portion and said measured workpiece corresponding to any of said spacing compensation units is smaller than said preset target spacing value when there exists no distance between said target portion and said measured workpiece corresponding to any of said spacing compensation units is less than said preset target spacing value.

In one embodiment, a plurality of said spacing compensation units are provided between said operating workpiece and said first support layer, the plurality of said spacing compensation units are evenly distributed on said operating workpiece.

In one embodiment, said operating workpiece is a probe layer and the plurality of said sensors is a plurality of probes arranged on said probe layer.

In one embodiment, said spacing compensation units correspond to the same number of said sensors.

In one embodiment, said spacing compensation unit comprises any one of the following: a piezoelectric element, a thermal expansion element, and a flat capacitor.

### Description of the drawings

FIG. 1 is a block schematic diagram of an operating device according to a first embodiment of the present application;
FIG. 2 is a schematic diagram of an operating device according to a first embodiment of the present application before distributed spacing compensation, wherein the operating device includes one spacing compensation unit;
FIG. 3 is a schematic diagram of an operating device according to a first embodiment of the present application after distributed spacing compensation, wherein the operating device includes one spacing compensation unit;
FIG. 4 is a schematic diagram of an operating device according to a first embodiment of the present application before distributed spacing compensation, wherein the operating device includes a plurality of spacing compensation units;
FIG. 5 is a schematic diagram of an operating device according to a first embodiment of the present application after distributed spacing compensation, wherein the operating device includes a plurality of spacing compensation units;
FIG. 6 is a schematic diagram of a portion of a single spacing compensation unit, a probe, and a first support layer of an operating device according to a first embodiment of the present application;
FIG. 7 is a schematic diagram of an operating device according to a first embodiment of the present application, wherein the operating workpiece is a probe layer, and the plurality of sensors are a plurality of probes on the probe layer;
FIG. 8 is a top view of the operating device shown in FIG. 7;
FIG. 9 is a schematic diagram of an operating device according to a second embodiment of the present application before distributed spacing compensation, wherein the operating device includes one spacing compensation unit;
FIG. 10 is a schematic diagram of an operating device according to a second embodiment of the present application after distributed spacing compensation, wherein the operating device includes one spacing compensation unit;
FIG. 11 is a schematic diagram of an operating device according to a second embodiment of the present application before distributed spacing compensation, wherein the operating device includes a plurality of spacing compensation units;
FIG. 12 is a schematic diagram of an operating device according to a second embodiment of the present application after distributed spacing compensation, wherein the operating device includes a plurality of spacing compensation units;
FIG. 13 is a specific flowchart of a distributed spacing compensation method between two workpieces according to a third embodiment of the present application;
FIG. 14 is a specific flowchart of a distributed spacing compensation method between two workpieces according to a fourth embodiment of the present application.

### Detailed description of embodiments

Each embodiment of the present application will be described in detail hereinafter in conjunction with the accompanying drawings for a clearer understanding of the purposes, features and advantages of the present application. It should be understood that the embodiments shown in the accompanying drawings are not intended to be a limitation of the scope of the present application, but are merely intended to illustrate the substantive spirit of the technical solution of the present application.

In the following description, certain specific details are set forth for the purpose of illustrating various disclosed embodiments to provide a thorough understanding of various disclosed embodiments. However, those skilled in the related art will recognize that embodiments may be practiced without one or more of these specific details. In other cases, familiar devices, structures, and techniques associated with the present application may not be shown or described in detail so as to avoid unnecessarily confusing the description of the embodiments.

Unless the context requires otherwise, throughout the specification and the claims, the words "including" and variants thereof, such as "comprising" and "having", are to be understood as open-ended and inclusive meaning, i.e., should be interpreted as "including, but not limited to".

References to "one embodiment" or "an embodiment" throughout the specification indicate that a particular feature, structure, or characteristic described in conjunction with an embodiment is included in at least one embodiment. Therefore, the occurrence of "in one embodiment" or "in an embodiment" at various locations throughout the specification need not all refer to the same embodiment. In addition, particular features, structures or characteristics may be combined in any manner in one or more embodiments.

As used in the specification and in the appended claims, the singular forms "a" and "an" include plural referents, unless the context clearly provides otherwise. It should be noted that the term "or" is normally used in its inclusive sense of "or/and", unless the context clearly provides otherwise.

In the following description, in order to clearly show the structure and working method of this application, it will be described with the help of many directional words, but words such as "front", "back", "left", "right", "outside", "inside", "outward", "inward", "up", "down", and the like should be understood as convenient terms and not as limiting terms.

A first embodiment of the present application relates to an operating device for performing a measuring or machining operation on a sample to be operated, for example, the sample to be operated is a wafer, a silicon wafer, a quartz wafer, etc., and taking the sample being a wafer as an example, the operating device is capable of measuring a three-dimensional morphology of the surface of the wafer, machining the photoresist on the surface of the wafer, performing a nanoimprint operation on the surface of the wafer, and the like.

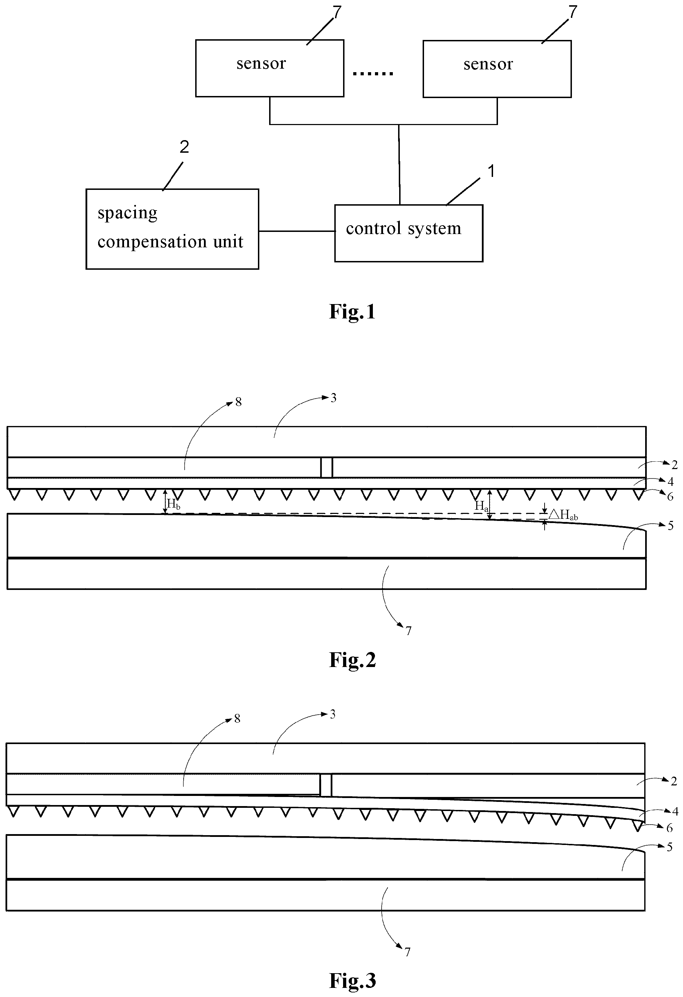

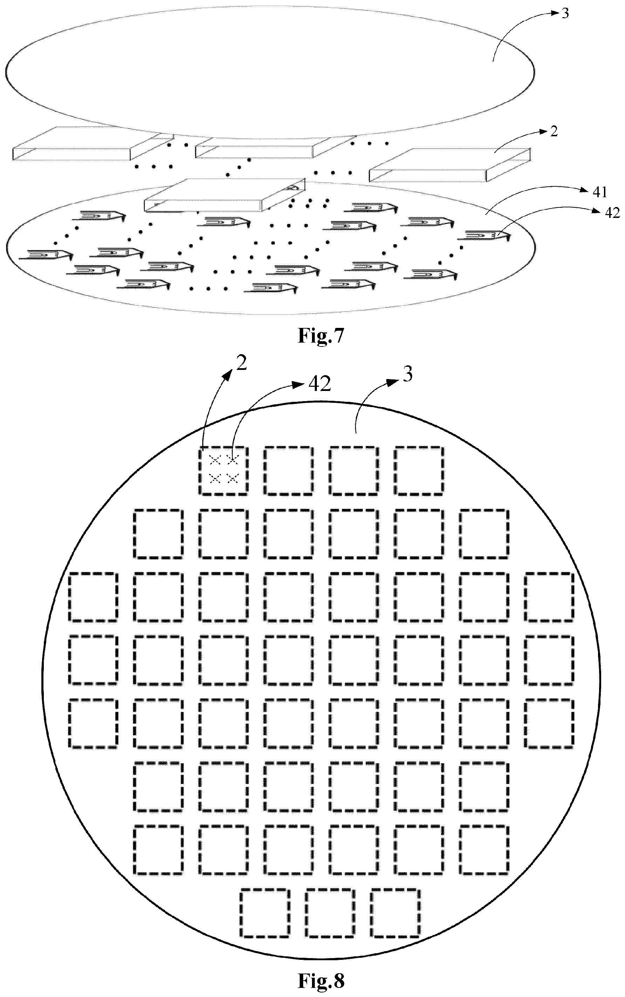

Referring to FIGS. 1 to 8, the operating device comprises: a control system 1, at least one spacing compensation unit 2 (only one spacing compensation unit is schematically depicted in FIG. 1), a first support layer 3, an operating workpiece 4, and a plurality of sensors 6 provided on the operating workpiece 4 and facing to a measured workpiece 5; said measured workpiece 5 is fixed to a second support layer 7. Wherein the measured workpiece 5 is the sample to be operated. Wherein the control system 1 may be a computer mainframe, a laptop computer, etc. including a controller, a processor, etc., and the sensors 6 may be sensors having a distance measuring function, such as photonic sensors, laser range sensors, electronic sensors, ion sensors, or atomic force sensors. It should be noted that the present embodiment as well as subsequent embodiments are illustrated with taking the operating workpiece 4 being located directly above the measured workpiece 5 as an example.

The control system 1 is communicatively connected to the spacing compensation units 2, and the control system 1 is communicatively connected to the sensors 6; the first support layer 3 is fixed to the operating workpiece 4 by the spacing compensation units 2; and the second support layer 7 is fixed to the measured workpiece 5. Each spacing compensation unit 2 corresponds to at least one sensor 6, and each spacing compensation unit 2 is overlapped spatially with a portion of the operating workpiece 4, and the sensor 6 corresponding to the spacing compensation unit 2 is provided on the portion of the operating workpiece 4 that is overlapped with the spacing compensation unit 2.

Specifically, the spacing compensation units 2 are fixed between the first support layer 3 and the operating workpiece 4, i.e., an upper surface of each spacing compensation unit 2 is fixed in contact with the first support 3 and a lower surface is fixed in contact with an upper surface of the operating workpiece 4, and the lower surface of each spacing compensation unit 2 covers a portion of the upper surface of the operating workpiece 4. The number of the spacing compensation units 2 is one or more, and each spacing compensation unit 2 corresponds to at least one sensor 6, i.e., the number of sensors 6 corresponding to each spacing compensation unit 2 may be one or more; each sensor 6 is fixed on a surface of the operating workpiece 4 facing the measured workpiece 5 (i.e., the lower surface of the operating workpiece 4), and the fixed position of each sensor 6 is the spatially overlapped portion of the corresponding spacing compensation unit 2 and the operating workpiece 4. Thus, at least one sensor 6 is fixed directly below each spacing compensation unit 2; when there exists a sensor 6 that does not correspond to any of the spacing compensation units 2, the fixed position of the sensor 6 is a portion of the lower surface of the operating workpiece 4 that is not spatially overlapped with any of the spacing compensation units 2. It is to be noted that when the sensor 6 is fixed on a portion of the lower surface of the operating workpiece 4 that is not spatially overlapped with the spacing compensation unit 2, a support auxiliary member 8 may also be provided on the operating workpiece 4 and the first support layer 3, the support auxiliary member 8 has a thickness that is the same as the initial thickness of the spacing compensation unit 2, which may provide support for the operating workpiece 4.

In this embodiment, the operating workpiece 4 may be made of a flexible material so as to be able to generate corresponding undulation with a change in the thickness of the spacing compensation unit 2. In addition, an elastic material may be provided at a portion of the spacing compensation unit 2 in contact with the operating workpiece 4, so that a fixation between the operating workpiece 4 and the spacing compensation unit 2 is maintained even when the thickness of the spacing compensation unit 2 changes.

As shown in FIGS. 2 and 3, the number of spacing compensation units 2 is 1. At this time, the spacing compensation unit 2 is configured to cover nearly half of the upper surface of the operating workpiece 4, and the plurality of sensors 6 is divided equally into two parts (the number of sensors 6 is 24 in the figures, for example), and the 12 sensors 6 included in the first part correspond to the spacing compensation unit 2, and the sensors 6 included in the first part are fixed on the portion of the lower surface of the operating workpiece 4.that is spatially overlapped with the spacing compensation unit 2, and the 12 sensors 6 included in the second part are fixed on the portion of the lower surface of the operating workpiece 4 that is not spatially overlapped with the spacing compensation unit 2.

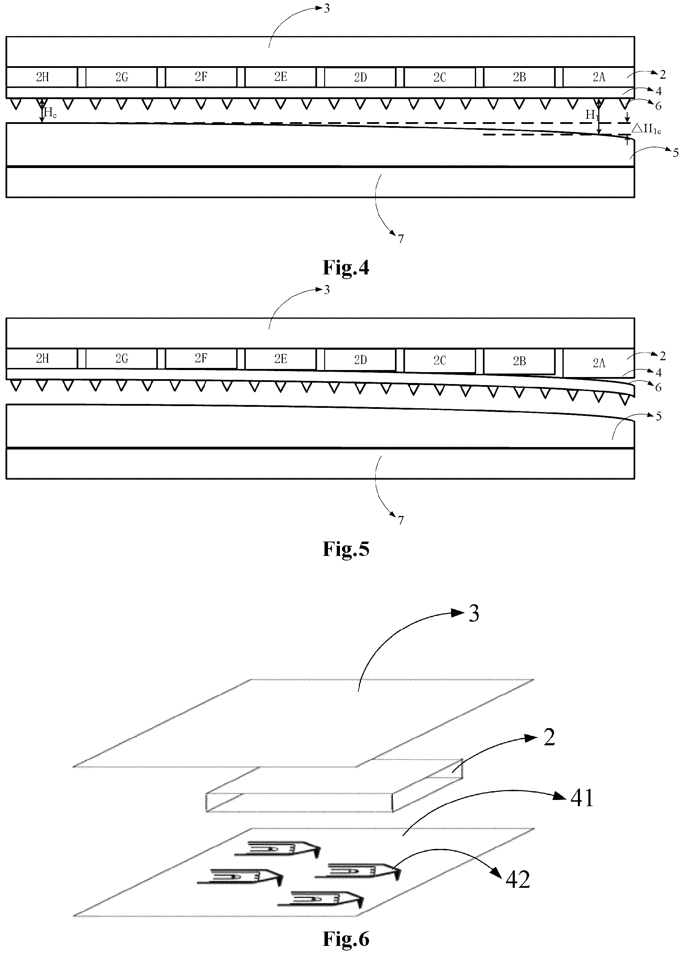

As shown in FIGS. 4 and 5, the number of spacing compensation units 2 is a plurality, a plurality of said spacing compensation units 2 are provided between said workpiece 4 and said first support layer 3, the plurality of spacing compensation units 2 may be uniformly distributed on the workpiece 4, i.e., the plurality of spacing compensation units 2 are uniformly distributed on an upper surface of the workpiece 4, there is a gap between neighboring spacing compensation units 2, and the number of the sensors 6 corresponding to each spacing compensation unit 2 may be equal or unequal, each sensor 6 corresponds to one spacing compensation unit 2, each sensor 6 is fixed on the portion of the lower surface of the operating workpiece 4 that is spatially overlapped with the spacing compensation unit 2 corresponding to the sensor 6; in FIG. 4 and FIG. 5, for example, the number of the spacing compensation units 2 is 8, and the number of the sensors 6 corresponding to each of the spacing compensation units 2 is 3; In FIGS. 4 and 5, for example, the number of spacing compensation units 2 is 8, which are noted as spacing compensation units 2A to 2H, respectively.

In one example, referring to FIGS. 6 to 8, the operating workpiece 4 is a probe layer 41, a plurality of probes 42 are provided on the lower surface of the probe layer 41, a plurality of probes 42 are uniformly distributed on the probe layer 41, the sensor 6 is the probe 42 of the probe layer 41, a plurality of spacing compensation units 2 are uniformly distributed on the probe layer 41, and each spacing compensation unit 2 is corresponded to 4 probes 42, i.e., 4 probes 42 are fixedly provided on the portion of the lower surface of the probe layer 41 that is spatially overlapped with each spacing compensation unit 2; thereby, the distance measurement characteristic of the probes 42 can be utilized to realize the distance measurement between the spacing compensation units 2 and the surface to be operated of the measured workpiece 5; wherein the optimal situation is that the spacing compensation units 2 and the probes 42 are one-to-one correspondences, i.e., each spacing compensation unit 2 corresponds to one probes 42 only, wherein each spacing compensation unit 2 is capable of performing the vertical spacing compensation for a position on the probe layer where a corresponding probe 42 is fixed. Wherein the plurality of probes 42 are capable of scanning and measuring the three-dimensional topography of the surface to be operated on the measured workpiece 5, and the operating device is capable of measuring physical and chemical quantities, scanning probe lithography (SPL), generating electrons, generating photons, and using the probe to introduce ions into the surface to be operated for ion implantating, and the like.

In this embodiment, the sensors 6 are capable of measuring the distance between the operating workpiece 4 and a corresponding position on the surface to be operated of the measured workpiece 5; specifically, the position on the surface to be operated of the measured workpiece 5 corresponding to each sensor 6 is a surface region on the surface to be operated of the measured workpiece 5, and the surface region corresponding to each sensor 6 is located directly below this sensor 6, i.e., each sensor 6 is used to measure the distance between the operating workpiece 4 and the corresponding surface region on the surface to be operated of the measured workpiece 5, and each sensor 6 sends the measured distance to the control system 1. The surface region may be any of the following: a pixel point, a line formed by a plurality of pixel points, and a surface combined by a plurality of pixel points; i.e., the surface region on the surface to be operated may be divided according to the pixel points, with each pixel point serving as a surface region; or the surface region on the surface to be operated is divided according to lines, with each surface region being a line formed by a plurality of adjacent pixel points; or, the surface region on the surface to be operated is divided according to surfaces, with each surface region being a surface formed by a combination of a plurality of adjacent pixel points.

The control system 1 is used to control each spacing compensation unit 2 to adjust the distance between a corresponding target portion on the operating workpiece 4 and the measured workpiece 5 according to the distance measured by each sensor 6, so as to make the shapes of the two opposite surfaces between the operating workpiece 4 and the measured workpiece 5 matched; the target portion is the portion of the operating workpiece 4 that is overlapped with the spacing compensation unit 2.

Since the shape of the lower surface of the operating workpiece 4 matches the shape of the surface to be operated of the measured workpiece 5, the control system, when adjusting the operating workpiece 4 up and down in the vertical direction, is still able to keep the distance of the lower surface of the operating workpiece 4 relative to the surface to be operated of the measured workpiece 5, which facilitates the operating workpiece 4 to carry out the operations such as measuring or machining of the measured workpiece 5. The spacing compensation process is described in detail below as follows:
When the number of the spacing compensation units 2 is one, referring to FIG. 2, the control system 1, after receiving the distances measured by all of the sensors 6, is capable of obtaining the distance between a target portion of an operating workpiece 4 corresponding to the spacing compensation unit 2 and the measured workpiece 5 based on the distances measured by the 12 sensors 6 included in the first portion corresponding to the spacing compensation unit 2, for example, calculating the average value of the distances measured by a plurality of sensors 6 corresponding to the spacing compensation unit 2 as the distance Hₐ between the target portion corresponding to the spacing compensation unit 2 and the measured workpiece 5; the portion of the operating workpiece 4 that is not spatially overlapped with the spacing compensation unit 2 is referred to as a reference portion, and the 12 sensors 6 included in the second portion are fixed to the reference portion, so that it is able to obtain a distance H_{b} between the reference portion and the measured workpiece 5 based on the distances measured by the 12 sensors 6 included in the second portion; the control system 1 subtracts the distance H_{b} from the distance Hₐ to obtain the distance difference ΔH_{ab} between the target portion of the operating workpiece 4 and the reference portion with respect to the surface to be operated, which reflects the undulation of the surface to be operated on the measured workpiece 5 and the undulation of the lower surface of the operating workpiece 4, and since the target portion of the operating workpiece 4 is fixed together with the distance compensation unit 2, it is possible to adjust the distance between the target portion of the operating workpiece 4 and the surface to be operated of the measured workpiece 5 by adjusting the thickness of this distance compensation unit 2, so as to make the distances between the target portion of the operating workpiece 4 and the reference portion with respect to the surface to be operated equal; specifically, when ΔH_{ab} is greater than 0, it means that the distance Hₐ between the target portion of the operating workpiece 4 and the surface to be operated is greater than the distance H_{b} between the reference portion of the operating workpiece 4 and the surface to be operated, and at this time, a control signal for controlling the thickness of the spacing compensation unit 2 to reduce by ΔH_{ab} is generated, and then the spacing compensation unit 2 is capable of adjusting its own thickness to reduce by ΔH_{ab} after receiving the control signal, so as to make the distances between the target portion and the reference portion of the operatiing workpiece 4 with respect to the surface to be operated equal; when ΔH_{ab} is less than 0, it means that the distance Hₐ between the target portion of the operating workpiece 4 and the surface to be operated is less than the distance H_{b} between the reference portion of the operating workpiece 4 and the surface to be operated, and at this time, a control signal for controlling the thickness of the spacing compensation unit 2 to increase by ΔH_{ab} is generated, and then the spacing compensation unit 2 is capable of adjusting its own thickness to increase by ΔH_{ab} after receiving the control signal, so as to make the distances between the target portion of the operating workpiece 4 and the reference portion with respect to the surface to be operated equal, referring to FIG. 3.

When the number of spacing compensation units 2 is a plurality, the greater the number of spacing compensation units 2, the better the effect of spacing compensation, i.e., the higher the shape match of the two opposite surfaces between the operating workpiece 4 and the measured workpiece 5 after spacing compensation.

The control system 1 is capable of obtaining the distance between the target portion corresponding to each spacing compensation unit 2 and the measured workpiece 5 based on the distances measured by the sensors 6 corresponding to each spacing compensation unit 2.

The control system 1 is used to control each spacing compensation unit 2 to adjust the distance between the corresponding target portion and the measured workpiece 5, and the adjusted distances between the target portions corresponding to the spacing compensation units 2 and the measured workpiece 5 are equal, so as to make the shapes of the two surfaces of the operating workpiece 4 and the measured workpiece 5 matched.

In one example, the control system 1 is used to generate a control signal for controlling the distance equal to the reference target spacing value corresponding to each spacing compensation unit 2 based on the difference between the distance between the target portion corresponding to each spacing compensation unit 2 and the measured workpiece 5 and the reference target spacing value; the spacing compensation unit 2 is used to adjust the distance between the target portion corresponding to each spacing compensation unit and the measured workpiece 5 to be equal to the reference target spacing value based on the received control signal.

The control system 1 is used to select the distance between the target portion and the measured workpiece 5 that is smaller than the preset target spacing value as the reference target spacing value when the distance between the target portion corresponding to any of the spacing compensation units 2 and the measured workpiece 5is smaller than the preset target spacing value.

The control system 1 is used to control the first support layer 3 to drive the operating workpiece 4 toward the measured workpiece 5 when tthe distance between the target portion corresponding to any of the spacing compensation units 2 and the measured workpiece 5 is not less than the preset target spacing value, so as to make the distance between the target portion corresponding to any of the spacing compensation units 2 and the measured workpiece 5 less than the preset target spacing value.

Taking the operating device of FIG. 4 as an example, a plurality of spacing compensation units 2 is equivalent to dividing the operating workpiece 4 into a plurality of target portions, and the control system 1, after receiving the distances sent by all of the sensors 6, calculates the distances between the target portions of the operating workpiece 4 corresponding to the spacing compensation unit 2 and the measured workpiece 5 for each spacing compensation unit 2 based on the distances measured by the three sensors corresponding to this spacing compensation unit 2, thereby being able to obtain the distances between the target portions of the operating workpiece 4 and the measured workpiece 5, and the change in the distance between each target portion and the measured workpiece reflects the change in the undulation of the surface to be operated of the measured workpiece 5 and the change in the undulation of the lower surface of the operating workpiece 4.

A target spacing value is preset in the control system 1, the preset target spacing value is an effective distance at which the operating workpiece 4 measures or machines the measured workpiece 5; if the distance between any of the target portions and the measured workpiece 5 is less than the preset target spacing value, a distance less than the preset target spacing value may be selected therefrom as the reference target spacing value.

If the distance between any target part and the measured workpiece 5 is not less than the preset target distance value, it means that the operating workpiece 4 is overall farther from the measured workpiece 5, and at this time, it is impossible to make the operating workpiece 4 enter the effective distance for measuring or machining the measured workpiece 5 only by means of the distance compensation unit 2; the control system 1 first drives the first support layer 3 to drive the operating workpiece 4 towards the measured workpiece 5 by the driving device built in the first support layer 3 or the driving device connected with the first support layer 3, causing the operating workpiece 4 to overall approach the measured workpiece 5, and continuously detects the distance during the movement until the distance between at least one target portion of the operating workpiece 4 and the measured workpiece 5 is less than a preset target spacing value. When the distance between any of the target portions and the measured workpiece 5 is less than the preset target spacing value, a distance less than the preset target spacing value can be selected therefrom as a reference target spacing value.

The control system 1, after selecting the reference target spacing value, subtracts the distance between each target portion and the measured workpiece 5 from the reference target spacing value to obtain the distance difference to be adjusted for each target portion, and the control system will generate the control signal corresponding to each target portion based on the distance difference to be adjusted for each target portion, and sends the control signal corresponding to each target portion to the spacing compensation unit 2 corresponding to each target portion, and each spacing compensation unit 2 will adjust its own thickness according to the received control signal, so that the distance between the corresponding target portion and the measured workpiece 5 is equal to the reference target spacing value.

Take the spacing compensation unit 2A in FIG. 4 as an example, the distance between the spacing compensation unit 2H and the surface of the measured workpiece 5 is taken as the reference target spacing value H_{c}, and the distance between the target portion corresponding to the spacing compensation unit 2A and the measured workpiece 5 is Hi , and the control system 1 calculates the difference ΔH_{1c} by subtracting the reference target spacing value H_{c} from the distance Hi, and the difference ΔH_{1c} characterizes the thickness required to be adjusted for the spacing compensation unit 2A. When ΔH_{1c} is greater than 0, it means that the distance Hi between the target portion corresponding to the spacing compensation unit 2A and the measured workpiece 5 is greater than the reference target spacing value H_{c}, and at this time, a control signal for controlling the thickness of the spacing compensation unit 2A to reduce by ΔH_{1c} is generated, and then the spacing compensation unit 2A is capable of adjusting its own thickness to reduce by ΔH_{1c} after receiving the control signal, so that the distance Hi between the target portion corresponding to this spacing compensation unit 2A and the measured workpiece 5 is equal to the reference target spacing value H_{c}; when ΔH_{1c} is less than 0, it means that the distance Hi between the target portion corresponding to this spacing compensation unit 2A and the measured workpiece 5 is less than the reference target spacing value H_{c} , and then a control signal for controlling the thickness of the spacing compensation unit 2A to increase by ΔH_{1c} is generated, and then the spacing compensation unit 2A is able to adjust its own thickness to increase by ΔH_{1c} after receiving the control signal, so that the distance Hₐ between the target portion corresponding to this spacing compensation unit 2A and the measured workpiece 5 is equal to the reference target spacing value H_{c}.

By repeating the above process, it is possible to make the distance between the target portion corresponding to each of the spacing compensation units 2 (spacing compensation unit 2B to spacing compensation unit 2G) and the measured workpiec 5 equal to the reference target spacing value H_{c}, thereby realizing distributed distance compensation for a plurality of target portions included in the operating workpiece 4, so as to make the shape of the lower surface of the operating workpiece 4 match that of the surface to be operated of the measured workpiece 5, referring to Fig. 5.

In this embodiment, the spacing compensation unit 2 comprises any one of the following: a piezoelectric element, a thermal expansion element, and a flat capacitor.

When the spacing compensation unit 2 comprises a piezoelectric element, the piezoelectric element can deform in the thickness direction (i.e., the vertical direction) according to the applied voltage, and at this time, the control system 1 is capable of generating a control signal of the corresponding voltage based on the amount of thickness change required to be adjusted for the spacing compensation unit 2, and this voltage is applied to the piezoelectric element, so as to cause a change in the thickness of the piezoelectric element, i.e., to enable the adjustment of the distance between the target portion corresponding to the spacing compensation unit 2 and the measured workpiece 5.

When the spacing compensation unit 2 comprises a thermal expansion element and a heating element provided adjacent to the thermal expansion element, the thermal expansion element is capable of deforming in the thickness direction (i.e., in the vertical direction) according to the temperature, and at this time, the control system 1 generates a control signal of a corresponding voltage on the basis of the amount of the thickness change required to be adjusted for the spacing compensation unit 2, and the control signal is applied to the heating element, so that the temperature of the heating element can be controlled, and then the heating element is able to heat the thermal expansion element, thereby causing the thickness of the thermal expansion element to change, i.e., enabling the adjustment of the distance between the target portion corresponding to the spacing compensation unit 2 and the measured workpiece 5.

When the spacing compensation unit 2 comprises a flat plate capacitor, the spacing of the two flat plates of the flat plate capacitor can be varied in the thickness direction (i.e., in the vertical direction) according to the applied voltage, whereby the control system 1 is able to generate a control signal of a corresponding voltage based on the amount of the thickness change required to be adjusted for the spacing compensation unit 2, this voltage is applied to the flat plate capacitor, so as to make the spacing of the two flat plates of the flat plate capacitor vary accordingly, thereby enabling the adjustment of the height of the first workpiece 32 in the vertical direction, i.e., enabling the adjustment of the distance between the target portion corresponding to the spacing compensation unit 2 and the workpiece 5 under test.

This embodiment provides an operating device comprising: a control system, at least one spacing compensation unit, a first support layer, an operating workpiece, and a plurality of sensors provided on the operating workpiece and facing to a measured workpiece, the control system is communicatively connected to the spacing compensation units, the control system is communicatively connected to the sensors; the first support layer is fixed together with the operating workpiece by the spacing compensation units; the second support layer is fixed fixed together with the measured workpiece; each spacing compensation unit corresponds to at least one sensor, each spacing compensation unit is spatially overlapped with a portion of the operating workpiece, and the sensors corresponding to the spacing compensation unit are arranged on the portion of the operating workpiece overlapped with the spacing compensation unit; the sensors are capable of measuring distances between the operating workpiece and corresponding positions on a surface to be operated of the measured workpiece, and the control system is capable of controlling the spacing compensation units to adjust the distance between the corresponding target portion of the operating workpiece and the measured workpiece based on the distance measured by the sensors, the target portion is the portion of the operating workpiece overlapped with the spacing compensation unit, and the shapes of the two opposite surfaces between the operating workpiece and the measured workpiece are matched after adjusting. That is, the lower surface of the operating workpiece can be divided into a plurality of portions for distributed spacing compensation, and the shapes of the two opposite surfaces between the operating workpiece and the measured workpiece are matched after distributed spacing compensation, so that the distance between the lower surface of the operating workpiece and the surface to be operated of the measured workpiece is kept relatively consistent, which facilitates the operations such as measuring or machining of the measured workpiece by the operating workpiece, and the accuracy of measuring and machining of the operating workpiece is improved.

A second embodiment of the present application relates to an operating device for performing a measuring or machining operation on a sample to be operated, the sample to be operated is, for example, a wafer, a silicon wafer, a quartz wafer, etc., and taking the sample being a wafer as an example, the operating device is capable of measuring a three-dimensional morphology of a wafer surface, machining a photoresist on the wafer surface, and performing a nanoimprint operation on the wafer surface, and the like.

Referring to FIGS. 1 and 9 to 12, the operating device comprises: a control system 1, at least one spacing compensation unit 2, a first support layer 3, and a plurality of sensors 6. Wherein said plurality of sensors 6 faces to a measured workpiece 5 fixed to a second support layer 7, and the measured workpiece 5 is a sample to be operated. The control system 1 may be a computer mainframe, a laptop computer, etc. including a controller, a processor, etc., and the sensors 6 may be sensors having a distance measuring function, for example, photonic sensors, laser range sensors, electronic sensors, ionic sensors, or atomic force sensors. It should be noted that this embodiment as well as subsequent embodiments are illustrated with the operation workpiece 4 being located directly above the measured workpiece 5 as an example.

In this embodiment, the plurality of sensors 6 is a plurality of probes, for example, a surface formed by the plurality of sensors 6 may be a surface formed by the tips of a plurality of probes; the plurality of probes are capable of scanning and measuring the three-dimensional topography of the surface to be operated on the measured workpiece 5, and at this time, the operating device is capable of measuring physical quantities and chemical quantities, performing scanning probe lithography (SPL), generating electrons, generating photons of the surface to be operated of the samples (e.g., wafers, silicon wafers, quartz wafers, etc.), as well as using the probe to introduce ions into the surface to be operated for ion implantating.

The control system 1 is communicatively connected to the spacing compensation units 2, and the control system 1 is communicatively connected to the sensors 6; each of the spacing compensation units 2 corresponds to at least one of the sensors 6, i.e., the number of sensors 6 corresponding to each of the spacing compensation units 2 may be one or more; one surface of the spacing compensation units 2 is fixed to the first support layer 3, and the corresponding sensors 6 are fixed to the other surface of the spacing compensation units 2; so that the corresponding sensors 6 are fixed to the surface of the each spacing compensation unit facing to the measured workpiece, when there are sensors 6 that do not correspond to any of the spacing compensation units 2, a support auxiliary member 8 may be provided on the lower surface of the first support layer 3 of the operating device, the thickness of the support auxiliary member 8 is the same as the initial thickness of the spacing compensation units 2, and the sensors 6 that do not correspond to any of the spacing compensation units 2 are fixed to the surface of the support auxiliary member 8 facing to the measured workpiece 5.

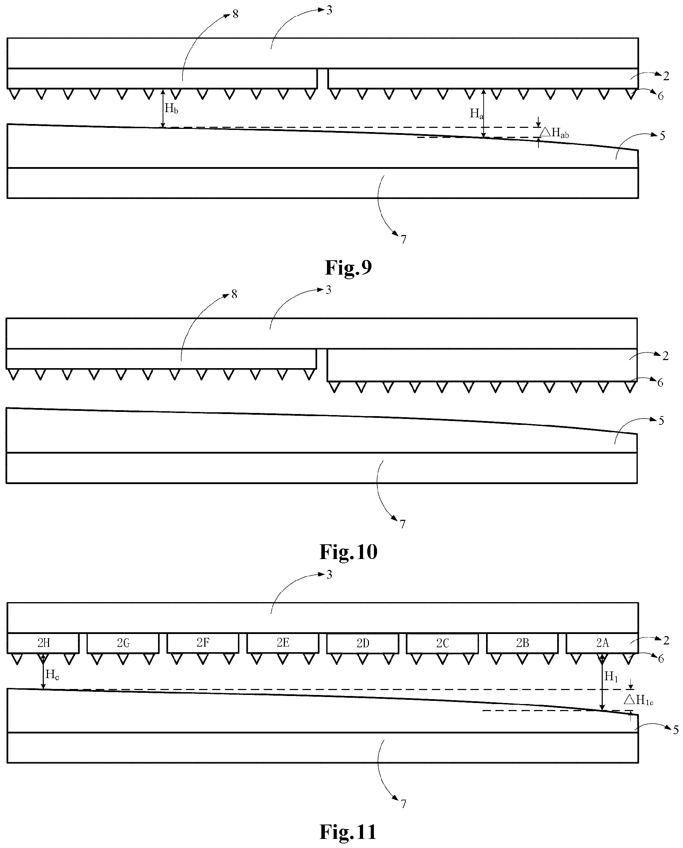

As shown in FIGS. 9 and 10, the number of spacing compensation units 2 is one, the spacing compensation unit 2 is fixed to the first support layer 3, and the plurality of sensors 6 are evenly divided into two parts (the number of sensors 6 is 24 in the figure as an example), and the 12 sensors 6 included in the first part correspond to the spacing compensation unit 2, and the sensors 6 included in the first part are fixed on the surface of the spacing compensation unit 2 facing to the measured workpiece 5, and the 12 sensors 6 included in the second part are fixed on the surface of the support auxiliary member 8 facing to the measured workpiece 5.

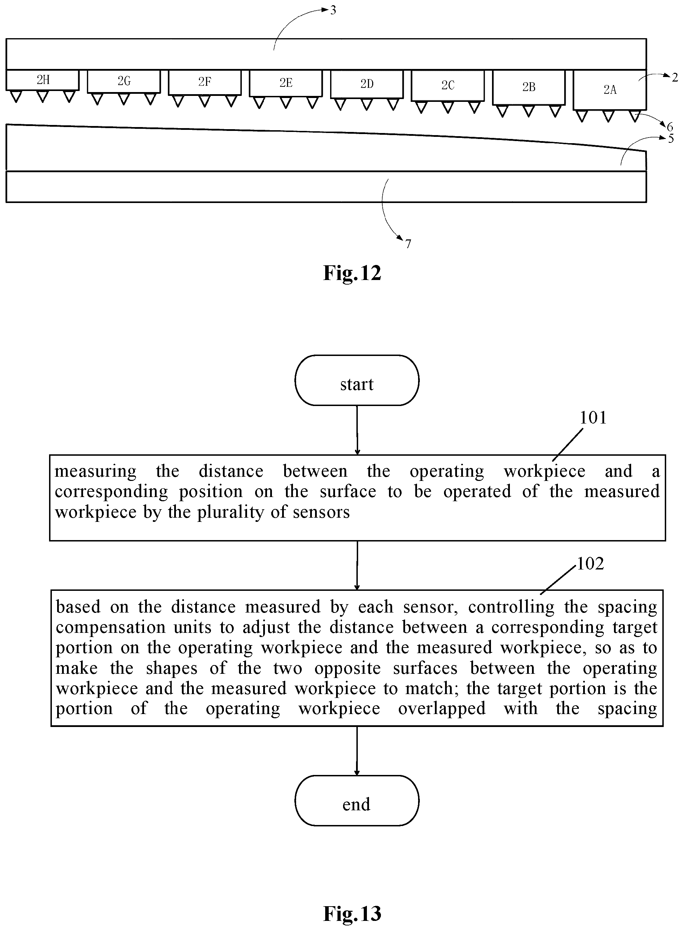

As shown in FIGS. 11 and 12, the number of spacing compensation units 2 is a plurality, and the plurality of spacing compensation units 2 may be uniformly distributed on the first support layer 3, i.e., the plurality of spacing compensation units 2 are uniformly arranged on the lower surface of the first support layer 3, and there is a gap between the adjacent spacing compensation units 2, and the number of sensors 6 corresponding to each spacing compensation unit 2 may be equal or unequal, and each of the sensors 6 corresponds to one spacing compensation unit 2, the sensors 6 are fixed to a portion of the lower surface of the operating workpiece 4 spatially overlapped with the spacing compensation unit 2 corresponding to the sensors 6; in FIGS. 11 and 12, for example, the number of sensors 6 corresponding to each spacing compensation unit 2 is three and in FIGS. 11 and 12, for example, the number of spacing compensation units 2 is eight, which are denoted as the spacing compensation units 2A to 2H, respectively.

In this embodiment, the sensor 6 is capable of measuring a distance between the corresponding spacing compensation unit 2 and a corresponding position on the measured workpiece 5. Specifically, if the sensor 6 is a probe, the sensor 6 is capable of measuring the distance between the tip of the probe and the corresponding position on the measured workpiece; if the spacing compensation unit 2 corresponds to only one sensor 6, the distance measured by the sensor 6 is the distance between the spacing compensation unit 2 and the measured workpiece 5; if the spacing compensation unit 2 corresponds to a plurality of sensors 6, an average value of the distances measured by the plurality of sensors 6 is calculated as the distances between the spacing compensation unit 2 and the measured workpiece 5.

Wherein the position on the surface to be operated of the measured workpiece 5 corresponding to the sensor 6 is a surface region on the surface to be operated of the measured workpiece 5, and the surface region corresponding to each of the sensors 6 is located directly below the sensor 6, i.e., each of the sensors 6 is used to measure the distance between the corresponding spacing compensation unit 2 and the corresponding surface region on the surface to be operated of the measured workpiece 5, and each of the sensors 6 will send the measured distance to the control system. The surface region may be any of the following: a pixel point, a line formed by a plurality of pixel points, and a surface combined by a plurality of pixel points; i.e., the surface region on the surface to be operated of the measured workpiec 5 may be divided in accordance with the pixel points, with each pixel point serving as a surface area; or, the surface region on the surface to be operated of the measured workpiec 5 may be divided in accordance with the lines, with each surface region being a line formed by a plurality of neighboring pixel points; or the surface region on the surface to be operated of the measured workpiece 5 is divided in accordance with the surfaces, with each surface region being a surface formed by a combination of adjacent plurality of pixel points.

The control system 1 is used to control and adjust the distances between the spacing compensation units 2 and the measured workpiece 5 based on the distances measured by the sensors 6, so as to make the shape of the surface formed by the plurality of sensors 6 match that of the surface to be operated of the measured workpiece 5.

Since the shape of the surface formed by the plurality of sensors 6 matches to that of the surface to be operated of the measured workpiece 5, the control system is still able to keep the distance between the surface formed by the plurality of sensors 6 and the surface to be operated of the measured workpiece 5 consistent when controlling the first support layer 3 to be adjusted upward or downward in the vertical direction, so that the operation device can perform operations such as measuring or machining on the measured workpiece 5 using the plurality of sensors 6. The spacing compensation process is described in detail below as follows:
When the number of the spacing compensation units 2 is one, referring to FIG. 9, the control system 1, after receiving the distances measured by all of the sensors 6, is capable of obtaining the distance between the spacing compensation unit 2 and the measured workpiece 5 based on the distances measured by the 12 sensors 6 included in the first portion corresponding to the spacing compensation unit 2, for example, by calculating the average value of the distances measured by the plurality of sensors 6 corresponding to the spacing compensation unit 2 as the distance Hₐ between the spacing compensation unit 2 and the measured workpiece 5; the 12 sensors 6 included in the second part are fixed to the surface of the support member 8 facing the measured workpiece 5, so that the distance H_{b} between the support auxiliary member 8 and the measured workpiece 5 can be obtained based on the distances measured by the 12 sensors 6 included in the second part; the control system 1 subtracts the distance H_{b} from the distance Hₐ to obtain the distance difference ΔH_{ab} between the spacing compensation unit 2 and the support auxiliary member 8 with respect to the surface to be operated of the measured workpiece 5, which reflects the undulation of the surface formed by the plurality of sensors 6 and the undulation of the surface to be operated of the measured workpiece 5, since the 12 sensors 6 included in the first part are fixed together with the spacing compensation unit 2, the distance between the surface formed by the 12 sensors 6 included in the first part and the surface to be operated of the measured workpiece 5 may be adjusted by adjusting the thickness of the spacing compensation unit 2, so that the distances between the surface formed by the 12 sensors 6 in the first part and the surface formed by the 12 sensors 6 in the second part with respect to the surface to be operated are equal; specifically, when ΔH_{ab} is greater than 0, it means that the distance Hₐ between the spacing compensation unit 2 and the surface to be operated is greater than the distance H_{b} between the support auxiliary member 8 and the surface to be operated, at this time a control signal for controlling the thickness of the spacing compensation unit 2 to reduce by ΔH_{ab} is generated, and then the spacing compensation unit 2 is capable of adjusting its own thickness to reduce by ΔH_{ab} after receiving the control signal, such that the distance between the face formed by the 12 sensors 6 included in the first and the face formed by the 12 sensors 6 included in the second section. The face formed by the 12 sensors 6 included in the first part and the face formed by the 12 sensors 6 included in the second part are at an equal distance with respect to the surface to be operated; when ΔH_{ab} is less than 0, it means that the distance Hₐ between the spacing compensation unit 2 and the surface to be operated is less than the distance H_{b} between the support auxiliary member 8 and the surface to be operated, and at this time, a control signal for controlling the thickness of the spacing compensation unit 2 to increase by ΔH_{ab} is generated, and then the spacing compensation unit 2 is capable of adjusting its own thickness to increase by ΔH_{ab} after receiving the control signal, such that the distances between the surface formed by the 12 sensors 6 in the first part and the surface formed by the 12 sensors 6 in the second part with respect to the surface to be operated are equal, referring to FIG. 10.

When the number of spacing compensation units 2 is a plurality, the greater the number of spacing compensation units 2, the better the effect of the spacing compensation, i.e., the higher the shape match between the surface formed by the plurality of sensors 6 after the spacing compensation and the surface to be operated of the measured workpiece 5. Wherein, it is possible to set each sensor 6 to correspond to one spacing compensation unit 2, at this time there is no need to provide the support auxiliary member 8 in the operating device.

The control system 1 is capable of obtaining the distances between the spacing compensation units 2 and the measured workpiece 5 based on the distances measured by the sensors 6 corresponding to the spacing compensation units 2.

The control system 1 is used to control the spacing compensation units 2 to adjust the distances between the spacing compensation units 2 and the measured workpiece 5 to be equal, so that the surface formed by the plurality of sensors 6 matches to that of the surface to be operated of the measured workpiece 5.

In one example, the control system 1 is used to generate a control signal corresponding to the spacing compensation units 2 for controlling the distance to be equal to the reference target spacing value based on a difference between the distance between the spacing compensation unit 2 and the measured workpiece 5 and the reference target spacing value.

The spacing compensation unit 2 is used to adjust the distance between the spacing compensation unit and the measured workpiece 5 to be equal to the reference target spacing value according to the received control signal.

The control system 1 is used to select a distance between the spacing compensation unit 2 and the measured workpiece 5 that is smaller than a preset target spacing value as the reference target spacing value when the distance between any one of the spacing compensation units 2 and the measured workpiece 5 is smaller than the preset target spacing value.

The control system 1 is used to control the first support layer to drive the spacing compensation unit 2 to move toward the measured workpiece 5 when the distance between any of the spacing compensation units 2 and the measured workpiece 5 is not less than the preset target spacing value.

Taking the operating device in FIG. 11 as an example, the control system 1 calculates the distance between that spacing compensation unit 2 and the measured workpiece 5 based on the distances measured by the three sensors corresponding to that spacing compensation unit 2 for each spacing compensation unit 2 after receiving the distances sent by all of the sensors 6, thereby being able to obtain the distances between the spacing compensation units 2 and the measured workpiece 5, and the change in the distances between the spacing compensation units 2 and the measured workpiece 5 reflects the change in the undulation of the surface to be operated of the measured workpiece 5 and the change in the undulation of the surface formed by the plurality of sensors 6.

A target spacing value is preset in the control system 1, the preset target spacing value being an effective distance at which the operating device measures or machines the measured workpiece 5; if the distance between any of the spacing compensation units 2 and the measured workpiece 5 is less than the preset target spacing value, a distance less than the preset target spacing value may be selected therefrom as the reference target spacing value.

If the distance between any of the spacing compensation units 2 and the measured workpiece 5 is not less than a preset target spacing value, it means that the plurality of sensors 6 on the first support layer 3 are overall farther from the measured workpiece , and at this time it is impossible to make the plurality of sensors 6 enter an effective distance for measuring or machining the measured workpiece 5 only by the spacing compensation units 2; the control system 1 firstly drives the first support layer 3 to drive the plurality of spacing compensation units 2 to move toward the measured workpiece 5 by the driving device built into the first support layer 3, or the driving device connected to the first support layer 3, so that the plurality of spacing compensation units 2 overall approaches the measured workpiece 5, and continuously detects the distance during movement until the distance between at least one of the spacing compensation units 2 and the measured workpiece 5 is less than the preset target spacing value. When the distance between any of the spacing compensation units 2 and the measured workpiece 5 is less than the preset target spacing value, a distance less than the preset target spacing value may be selected therefrom as a reference target spacing value.

The control system 1, after selecting the reference target spacing value, subtracts the reference target spacing value from the distances between the spacing compensation units 2 and the measured workpiece 5, and obtains the distance differences to be adjusted of the spacing compensation units 2. The control signal will generate the control signals corresponding to the spacing compensation units 2 based on the distance differences to be adjusted of the spacing compensation units 2, and respectively send the control signals to the corresponding spacing compensation unit 2, and the spacing compensation units 2 will adjust their own thickness according to the received control signals, so that the distance between the spacing compensation unit 2 and the measured workpiece 5 is equal to the reference target spacing value.

Taking the spacing compensation unit 2A in Figure 11 as an example, the distance between the spacing compensation unit 2H and the surface of the measured workpiece 5 is taken as the reference target spacing value H_{c}, the distance between the spacing compensation unit 2A and the measured workpiece 5 is Hi, the control system 1 calculates the difference ΔH_{1c} of subtracting the reference target spacing value H_{c} from the distance Hi, the difference ΔH_{1c} characterizes the thickness required to be adjusted for the spacing compensation unit 2A, when ΔH_{1c} is greater than 0, it means that the distance Hi between the spacing compensation unit 2A and the measured workpiece 5 is greater than the reference target spacing value H_{c}, and at this time, a control signal for controlling the thickness of the spacing compensation unit 2A to reduce by ΔH_{1c} is generated, and then the spacing compensation unit 2A is able to adjust its own thickness to reduce by ΔH_{1c} after receiving the control signal, so that the distance Hi between the spacing compensation unit 2A and the measured workpiece 5 is equal to the reference target spacing value H_{c}; when Δ H_{1c} is less than 0, it means that the distance Hi between the spacing compensation unit 2A and the measured workpiece 5 is less than the reference target spacing value H_{c}, at this time, a control signal for controlling the thickness the spacing compensation unit 2A to increase by ΔH_{1c} is generated, and then the spacing compensation unit 2A is able to adjust its own thickness increase by ΔH_{1c} after receiving the control signal, so that the distance Hi between the spacing compensation unit 2A and the measured workpiece 5 is equal to the reference target distance H_{c}.

By repeating the above process, it is possible to make all the distances between the spacing compensation units 2 (spacing compensation unit 2B to spacing compensation unit 2G) and the measured workpiece 5 equal to the reference target spacing value H_{c}, and the distances between the surfaces formed by the sensors on the spacing compensation units 2 and the surface to be operated of the measured workpiece 5 are equal, thus realizing distributed distance compensation of the plurality of spacing compensation units 2 and making the shape of the surface formed by the plurality of sensors 6 to match to that of the surface to be operated of the measured workpiece 5, referring to FIG. 12.

In this embodiment, the spacing compensation unit 2 comprises any one of the following: a piezoelectric element, a thermal expansion element, and a flat capacitor.

When the spacing compensation unit 2 comprises a piezoelectric element, the piezoelectric element can deform in the thickness direction (i.e., the vertical direction) according to the applied voltage, and at this time, the control system 1 is capable of generating a control signal of the corresponding voltage based on the amount of thickness change required to be adjusted for the spacing compensation unit 2, and the voltage is applied to the piezoelectric element, so as to cause a change in the thickness of the piezoelectric element, which enables the adjustment of the distance between the spacing compensation unit 2 and the measured workpiece 5.

When the spacing compensation unit 2 comprises a thermal expansion element and a heating element arranged adjacent to the thermal expansion element, the thermal expansion element can deform in the thickness direction (i.e., in the vertical direction) according to the temperature, and at this time, the control system 1 generates a control signal of a corresponding voltage based on the amount of the thickness change required to be adjusted for the spacing compensation unit 2, and the control signal is applied to the heating element, thereby controlling the temperature of the heating element, and the heating element can then heat the thermal expansion element, causing the thickness of the thermal expansion element to change, i.e., enabling the distance between the spacing compensation unit 2 and the measured workpiece 5 to be adjusted.

When the spacing compensation unit 2 comprises a flat plate capacitor, the spacing of the two flat plates of the flat plate capacitor can be varied in the thickness direction (i.e., in the vertical direction) according to the applied voltage, whereby the control system 1 is able to generate a control signal of a corresponding voltage based on the amount of the change thickness required to be adjusted for the spacing compensation unit 2, this voltage is applied to the flat plate capacitor, causing a corresponding change in the spacing between the two flat plates of the flat plate capacitor, thereby making it possible to adjust the height of the first workpiece 32 in the vertical direction, i.e., making it possible to adjust the distance between the spacing compensation unit 2 and the measured workpiece 5.

This embodiment provides an operating device comprising: a control system, at least one spacing compensation unit, a first support layer, a second support layer, a measured workpiece and a plurality of sensors, the control system is communicatively connected to the spacing compensation units, the control system is communicatively connected to the sensors; each of the spacing compensation units corresponds to at least one sensor, one surface of the spacing compensation unit is fixed on the first support layer, and the other surface of the spacing compensation unit is fixed with the corresponding sensors; the sensors are used to measure the distances between the corresponding spacing compensation units and a corresponding position on the workpiece to be measured; the control system is used to control and adjust the distance between the spacing compensation unit and the measured workpiece based on the distances measured by the sensors, and after adjusting, the shape of the surface formed by the plurality of sensors match to that of the surface to be operated of the measured workpiece. That is, the surface formed by the plurality of sensors can be divided into a plurality of portions for distributed spacing compensation, and the shape of the surface formed by the plurality of sensors after distributed spacing compensation matches to the shape of the surface to be operated of the measured workpiece, so that the distance between the surface formed by the plurality of sensors and the surface to be operated of the measured workpiec is kept relatively consistent, which facilitates the measuring or machining of the measured workpiece by the operating device utilizing the plurality of sensors, and improves the accuracy of measuring and machining of the measured workpiece.

A third embodiment of the present application relates to a method for distributed compensating a spacing between two workpieces, applied to the operating device in the first embodiment. The operating device may perform vertical spacing compensation using the method for distributed compensating a spacing between two workpieces in this embodiment.

The specific flow of the method for distributed compensating a spacing between two workpieces of this embodiment is shown in FIG. 13.

Step 101, measuring a distance between the operating workpiece and a corresponding position on the surface to be operated of the measured workpiece by the plurality of sensors.

Step 102, based on the distance measured by each sensor, controlling the spacing compensation units to adjust the distance between a corresponding target portion on the operating workpiece and the measured workpiece, so as to make the shapes of the two opposite surfaces between the operating workpiece and the measured workpiece matched; the target portion is the portion of the operating workpiece overlapped with the spacing compensation unit.

Since the first embodiment and this embodiment correspond to each other, this embodiment can be implemented in conjunction with the first embodiment. The relevant technical details mentioned in the first embodiment are still valid in this embodiment, and the technical effect that can be achieved in the first embodiment can also be realized in this embodiment, so in order to reduce repetition, it will not be repeated herein. Accordingly, the relevant technical details mentioned in this embodiment can also be applied in the first embodiment.

In this embodiment, the sensors in the operating device are capable of measuring the distance between the operating workpiece and the corresponding position on the surface to be operated of the measured workpiece, and the control system is capable of controlling the spacing compensation units to adjust the distance between the corresponding target portion on the operating workpiece and the measured workpiece based on the distance measured by the respective sensors, the target portion is the portion of the operating workpiece overlapped with the spacing compensation unit, and the shapes of the two opposite surfaces between the adjusted operating workpiece and the measured workpiece are matched. That is, the lower surface of the operating workpiece can be divided into a plurality of portions for distributed spacing compensation, and the shapes of the two opposite surfaces of the operating workpiece after the distributed compensating for spacing and the measured workpiece are matched, so that the distance between the lower surface of the operating workpiece and the surface to be operated of the measured workpiece is kept relatively consistent, which facilitates the measuring or machining of the measured workpiece by the operating device, and improves the accuracy of measuring and machining of the measured workpiece.

A fourth embodiment of the present application relates to a method for distributed compensating a spacing between two workpieces, applied to the operating device of the second embodiment.

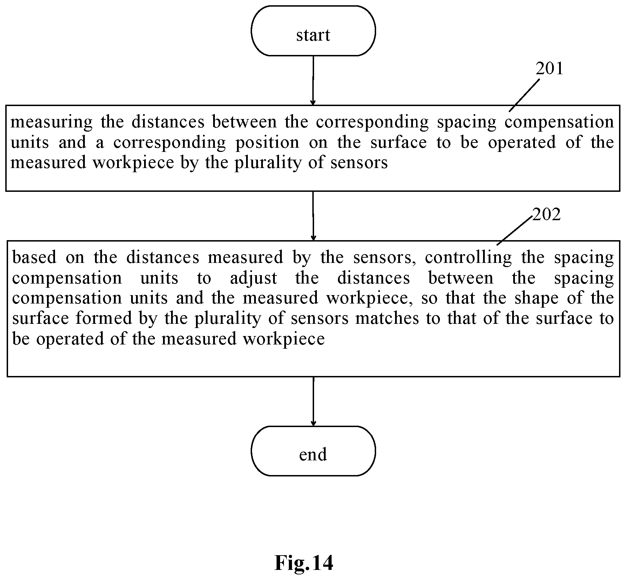

The specific flow of the method for distributed compensating a spacing between two workpieces of this embodiment is shown in FIG. 14.

Step 201, measuring distances between the corresponding spacing compensation units and a corresponding position on the surface to be operated of the measured workpiece by the plurality of sensors.

Step 202, based on the distances measured by the sensors, controlling the spacing compensation units to adjust the distances between the spacing compensation units and the measured workpiece, so that the shape of the surface formed by the plurality of sensors matches to that of the surface to be operated of the measured workpiece.

Since the second embodiment and this embodiment correspond to each other, this embodiment can be implemented in conjunction with the second embodiment. The relevant technical details mentioned in the second embodiment are still effective in this embodiment, and the technical effect that can be achieved in the second embodiment can also be realized in this embodiment, so in order to reduce repetition, it will not be repeated herein. Accordingly, the relevant technical details mentioned in this embodiment can also be applied in the second embodiment.

In this embodiment, the sensors in the operating device are used to measure distances between the corresponding spacing compensation units and a corresponding position on the measured workpiece; the control system is used to control and adjust the distances between the corresponding spacing compensation units and the measured workpiece based on the distances measured by the sensors, and after adjusting, the shape of the surface formed by the plurality of sensors matches to that of the surface to be operated of the measured workpiece. That is, the surface formed by the plurality of sensors can be divided into a plurality of portions for distributed spacing compensation, and the shape of the surface formed by the plurality of sensors after distributed spacing compensation matches to that of the surface to be operated of the measured workpiece, so that the distance between the surface formed by the plurality of sensors and the surface to be operated of the measured workpiece is kept relatively consistent, and this facilitates the measuring or machining of the measured workpiece by the operating device utilizing the plurality of sensors, and improves the accuracy of measuring and machining of the measured workpiece.

Preferred embodiments of the present application have been described in detail above, but it should be understood that aspects of the embodiments can be modified to employ aspects, features and ideas from various patents, applications, and publications to provide additional embodiments, if desired.

These and other variations to the embodiments can be made in view of the detailed description above. In the claims, the terms used should not be considered as limiting the specific embodiments disclosed in the specification and claims, but should be understood to include all possible embodiments together with the full scope of equivalents enjoyed by those claims.

## Claims

1. An operating device, **characterized in that**, comprising: a control system, at least one spacing compensation unit, a first support layer, an operating workpiece, and a plurality of sensors provided on said operating workpiece and facing a measured workpiece; said machined workpiece is fixed on a second support layer, said control system is communicatively connected to said spacing compensation units, said control system is communicatively connected to said sensors; said first support layer is fixed to said operating workpiece by said spacing compensation unit; said second support layer is fixed to said measured workpiece;
each of said spacing compensation units corresponds to at least one said sensor, each of said spacing compensation units is overlapped spatially with a portion of said operating workpiece, said sensor corresponding to said spacing compensation unit is provided on the portion of said operating workpiece overlapped with said spacing compensation unit;
said sensor is used for measuring a distance between said operating workpiece and a corresponding position on the surface to be operated of said workpiece;
said control system is used for controlling said spacing compensation units to adjust the distance between a corresponding target portion of said operating workpiece and said measured workpiece based on the distances measured by said sensors, so as to make the shapes of two opposite surfaces between said operating workpiece and said measured workpiece matched; said target portion is the portion of said operating workpiece overlapped with said spacing compensation unit.

2. The operating device according to claim 1, **characterized in that** the number of said spacing compensation units is a plurality, each of said sensors corresponds to one of said spacing compensation units;
said control system is used to obtain distances between said target portions corresponding to said spacing compensation units and said measured workpiece based on the distances measured by said sensors corresponding to said spacing compensation units;
said control system is used to control each of said spacing compensation units to adjust the distance between the corresponding said target portion and said measured workpiece, the distances between the said target portions corresponding to said spacing compensation units and said measured workpiece are equal after adjusting, so as to make the shapes of two opposite surfaces between said operating workpiece and said measured workpiece matched.

3. The operating device according to claim 2, **characterized in that** said control system is used to generate a control signal corresponding to each of said spacing compensation units for controlling a distance to be equal to said reference target spacing value based on the differences between the distances between said target portions corresponding to said spacing compensation units and said measured workpiece and said reference target spacing value;
said spacing compensation unit is used to adjust the distance between corresponding said target portion and said measured workpiece to be equal to said reference target spacing value, based on said control signal received.

4. The operating device according to claim 3, **characterized in that** said control system is used to select the distance between said target portion and said measured workpiece which is smaller than a preset target spacing value as said reference target spacing value, when the distance between said target portion corresponding to any of said spacing compensation units and said measured workpiece is less than said preset target spacing value;
said control system is used to control said first support layer to drive said operating workpiece to move towards said measured workpiece, so as to make the distance between said target portion corresponding to any one of said spacing compensation units and said measured workpiece less than the preset target spacing value, when the distance between said target portion corresponding to any one of said spacing compensation units and said measured workpiece is not less than said preset target spacing value.

5. The operating device according to claim 2, **characterized in that** a plurality of said spacing compensation units are provided between said operating workpiece and said first support layer, the plurality of said spacing compensation units are uniformly distributed on said operating workpiece.

6. The operating device according to claim 1, **characterized in that** said operating workpiece is a probe layer, and the plurality of said sensors is a plurality of probes provided in said probe layer.

7. The operating device according to claim 1, **characterized in that** each said spacing compensation unit corresponds to the same number of said sensors.

8. The operating device according to any one of claims 1 to 7, **characterized in that** said spacing compensation unit comprises any one of the following: a piezoelectric element, a thermal expansion element and a flat capacitor.

9. An operating device, **characterized in that**, comprising: a control system, at least one spacing compensation unit, a first support layer, and a plurality of sensors, said plurality of sensors face to a measured workpiece fixed on a second support layer;
said control system is communicatively connected to each said spacing compensation unit, said control system is communicatively connected to each said sensor; each said spacing compensation unit corresponds to at least one said sensor, one surface of said spacing compensation unit is fixed to said first support layer, the other surface of said spacing compensation unit is fixed with the corresponding sensors;
said sensor is used to measure the distance between the corresponding spacing compensation unit and a corresponding position on said measured workpiece;
said control system is used to control and adjust the distances between said spacing compensation unit and said measured workpiece, based on the distances measured by said sensors, so as to make the shape of the surface formed by said plurality of sensors match that of the surface to be operated of said measured workpiece.

10. The operating device according to claim 9, **characterized in that** the number of said spacing compensation units is a plurality, each of said sensors corresponding to one of said spacing compensation units;
said control system is used to obtain distances between said spacing compensation units and said measured workpiece based on the distances measured by said sensors corresponding to said spacing compensation units;
said control system is used to control said spacing compensation units to adjust the distances between said spacing compensation units and said measured workpiece to be equal, so as to make the shape of the surface formed by said plurality of sensors match that of the surface to be operated of said measured workpiece.

11. The operating device according to claim 10, **characterized in that** said control system is used to generate a control signal corresponding to each said spacing compensation unit for controlling the distance to be equal to a reference target spacing value based on the difference between the distance between each said spacing compensation unit and said measured workpiecet and the reference target spacing value;
said spacing compensation unit is used to adjust the distances between said spacing compensation units and said measured workpiece to be equal to said reference target spacing value, based on said control signal received.

12. The operating device according to claim 11, **characterized in that** said control system is used to select a distance between said spacing compensation units and said measured workpiece that is less than a preset target spacing value as said reference target spacing value, when the distance between any one of said spacing compensation units and said measured workpiece is less than the preset target spacing value;
said control system is used to control said first support layer to drive said spacing compensation unit to move towards said measured workpiece when the distance between any one of said spacing compensation units and said measured workpiece is not less than the preset target spacing value.

13. The operating device according to claim 9, **characterized in that** a plurality of said spacing compensation units are evenly distributed on said first support layer.

14. The operating device according to claim 9, **characterized in that** each said spacing compensation unit corresponds to the same number of said sensors.

15. The operating device according to claim 9, **characterized in that** the plurality of said sensors is a plurality of probes.

16. The operating device according to claims 9 to 15, **characterized in that** said spacing compensation unit comprises any one of the following: a piezoelectric element, a thermal expansion element and a flat capacitor.

17. A method for distributed compensating a spacing between two workpieces, **characterized in that**, applied to an operating device according to any one of claims 1 to 8, said method comprising:
measuring a distance between the operating workpiece and a corresponding position on the surface to be operated of the measured workpiece by a plurality of sensors;
based on the distance measured by each said sensor, controlling each spacing compensation unit to adjust the distance between a corresponding target portion on the operating workpiece and said measured workpiece, so as to make the shapes of two opposite surfaces between said operating workpiece and said measured workpiece matched; said target portion is the portion of said operating workpiece overlapped with said spacing compensation unit.

18. A method for distributed compensating a spacing between two workpieces, **characterized in that**, applied to an operating device according any one of claims 9 to 16, said method comprises:
measuring the distances between the corresponding spacing compensation units and a corresponding position on the surface to be operated of said measured workpiece by a plurality of sensors;
based on the distances measured by said sensors, controlling said spacing compensation units to adjust the distance between said spacing compensation unit and said measured workpiece, so as to make the shape of the surface formed by said plurality of sensors match that of the surface to be operated of said measured workpiece.
